# EUROPEAN PATENT APPLICATION

(11) **EP 1 385 197 A1**
(43) Date of publication of application: **28.01.2004**
(21) Application number: 03254632.7
(22) Date of filing: 23.07.2003
(51) Int. Cl.: H01L 21/3105

(54) **Planarizing a surface of a semiconductor wafer**

(30) Priority: 23.07.2002 US 201752
(71) Applicant: 1ST Silicon (Malaysia) SDN BHD, 93350 Kuching, Sarawak (MY)
(72) Inventor: Baek, Jae Hak, BDC Stampin, 93050 Kuching, Sarawak (MY)
(74) Representative: Harrison Goddard Foote

(57) **Abstract**

A method of planarizing a semiconductor wafer, comprising firstly, applying a photoresist layer on the irregular wafer surface to evenly coat over the undesirable topography of the wafer so as to provide a top surface of the photoresist layer that is substantially planar, and secondly, etching the photoresist and dielectric layer at substantially the same rate.

The flowability of the photoresist ensures even spread over the irregular surface to achieve a substantially planar top surface. The dielectric layer may preferably be etched further until the thickness of the layer is desirable for subsequent fabrication.

In one embodiment, the etchant may include any one of oxide, poly-silicon, metal, photoresist and polyimide etchants, or combinations thereof. Oxide etchants may be employed for etching dielectric material while poly-silicon and metal etchants may be employed for etching layers comprised of conductive structures or material.

## Description

### Technical Field

This invention relates to a method of planarization of a semiconductor wafer surface which planarity has been rendered irregular due to the underlying levels. Specifically, the method concerns the use of photolithography to substantially planarize an irregular surface of the wafer.

### Background Art

As the size of VLSI devices decreases, the circuit complexity and number of interconnects increases, resulting in lower tolerances to topological differences between cell and periphery area on the device. Such topological variances also make patterning, lithography and etching processes more susceptible to errors and failures or render unacceptable to quality control as these processes requires the wafer surfaces to be planar.

Circuit patterns are etched onto each layer of the wafer resulting in the layer surface becoming stepped into high and low plateaus. The stacking of a subsequent layer atop this patterned layer results in irregular top surface whereby protrusions arises due to the underlying high plateaus, and recesses due to the underlying low plateaus.

The non-planarity of the top surface is also caused by the cumulative non-planarity of all the underlying levels. Hence, as the number of underlying interconnecting levels increases, the degree of planarity of each level must be observed strictly so that the uppermost level is planar.

Various methods have been employed to planarize the surface, the most common being the chemical-mechanical polishing (CMP). However, it is well known that the CMP process does not provide a consistent planarity of the surface which may vary according to the underlying density of interconnect structures. A thicker dielectric layer is usually laid to overcome the effects of the underlying topological effects, thus reducing the total number of layers possible in a given thickness of a semiconductor device.

Additionally, the combination of chemical dissolution and mechanical abrasion used in a CMP process may also results in scratches, corrosion and residual slurry. Severe wafer-to-wafer variations in dielectric thickness due to systematic changes in CMP polish rate as the number of wafers polished increases is also a problem. Hence, the CMP process must be closely monitored throughout the polishing process and adjusted for each new device to be produced. This increases production costs and lost time as the fabrication equipment needs to be recalibrated after each lot of wafers is processed.

Generally, photolithography is used to etch the layers of the semiconductor wafer into patterns. Photoresist is a light-sensitive material, initially in liquid or soluble form, i.e. highly flowable. Upon exposure to light (or a particular wavelength of the spectrum) the photosensitive liquid polymerises and become insoluble. Light may be directed to polymerise the photoresist on those parts of the top layer according to the circuit patterns. Etchants may then be used to etch the exposed parts of the layer. The photoresist layer may then be dissolved.

There are attempts to use photolithography to achieve planarization as disclosed in the following prior art.

**US-6,280,644** (Martin, et. al.) by Agere Systems disclosed a method of planarizing an irregular surface of a semiconductor wafer comprising the steps of applying a photoresist material over recessed area and protruding areas of the irregular surface and employing photolithography to selectively remove portions of the photoresist from protruding areas of the irregular surface. The photoresist is then etched and the etching proceeds partially into protruding areas of the irregular surface.

Generally, this prior art process includes applying photoresist on a dielectric layer that exhibits effects of an underlying interconnect structure topography. The applied photoresist is then treated with a light source in a photolithic process. This method does not achieve planarization by etching the photoresist and dielectric layer alone and requires polishing the etched irregular surface to planar, including CMP.

**US-6,010,828** (Lippitt) by Lucent Technologies discloses a method of planarizing a photosensitive material, such as a photoresist, over an irregular surface of a semiconductor wafer. The steps include, firstly, passing radiation through a first glass medium and second fluid medium (such as water and gas) wherein the glass medium is interfaced with the fluid medium. Then, the radiation from the fluid medium is passed onto the photosensitive material which is interfaced with the second medium to expose the photosensitive material.

The first and second mediums and the photosensitive material have radiation absorption coefficients such that the radiation terminates substantially within a plane of the photosensitive material. Next, the exposed photosensitive material is etched to the plane. The first and second media may each have equal or different refractive index to allow minimal refraction to occur during radiation to promote uniform exposure of the photosensitive material so that the photoresist may be etched to a plane.

### Objects of Invention

Our invention endeavours to efficiently planarize semiconductor wafer surface with photolithography methods without requiring CMP finishing as required in the prior art.

Our process also dispense with the need for photolithographic arrangement of media combination with refractive coefficients to achieve planar exposure in order for the photoresist to be etched to a plane.

In particular, our process endeavours to provide an etching process that etches both the photoresist and the dielectric layer at substantially the same rate in order to achieve a planar wafer surface.

### Summary of Invention

The present invention discloses, as a general embodiment, a method of planarizing an irregular surface of a semiconductor wafer wherein a layer of photoresist is first applied on the irregular wafer surface to evenly coat over the undesirable topographic features of the wafer so as to provide a top surface of the photoresist layer that is substantially planar. Then the photoresist and dielectric layer are etched at substantially the same rate.

The flowability of the photoresist enables it to be evenly applied on and spread over the irregular wafer surface to achieve a substantially planar top surface. The photoresist layer and the dielectric layer underlying the photoresist may preferably be etched further until the thickness of the layer is desirably reduced for fabrication of subsequent layers.

In one embodiment, the etchant may include any one of oxide etchants, poly-silicon etchants, metal etchants, photoresist etchants and polyimide etchants, or combinations thereof. Oxide etchants may be employed for etching dielectric material while poly-silicon and metal etchants may be employed for etching layers comprised of conductive structures or material.

### Brief Description of the Drawings

Our photoresist etching planarization method may be described in fuller detail with references to the following drawings as specific examples or illustrations and which are not to be construed as delimiting the scope of the invention and the variety of other embodiments the process is capable of.
- FIGURE 1: shows in cross-sectional view the irregular top surface of a wafer;
- FIGURE 2: shows in cross-sectional view the irregular top surface being covered with photoresist;
- FIGURE 3: shows in cross-sectional view the etching of both the photoresist and dielectric layer; and
- FIGURE 4: shows in cross-sectional view the etching of dielectric layer to reduce the thickness of the layer.

### Detailed Description

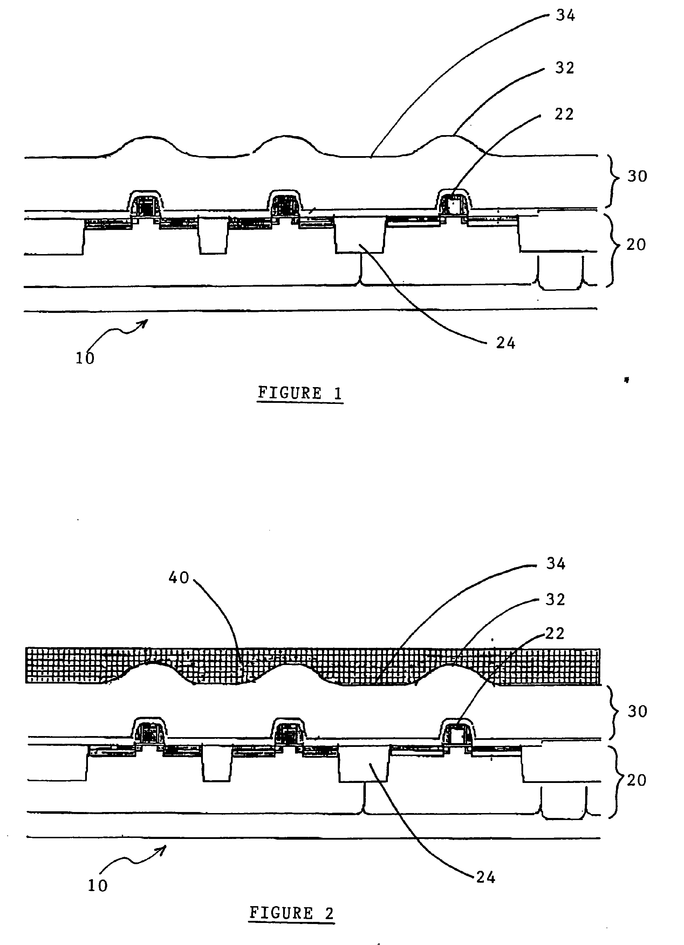

Referring to FIG. 1, the semiconductor wafer (10), which is being fabricated, may comprise of circuit patterns etched onto each layer of the wafer. For instance, the lower layer (20) may become stepped into high (22) and low (24) plateaus. The stacking of a subsequent layer (30) atop the lower patterned layer (20) results in irregular top surface whereby protrusions (32) arises due to the underlying high plateaus (22), and recesses (34) due to the underlying low plateaus (24).

As shown in FIG. 2, our method comprises, firstly, laying a layer of photoresist (40) over the irregular top surface layer (30). It will be appreciated that the evenness of the photoresist (40) application over the top surface layer (30) is due to the flowability of the photoresist liquid. The photoresist liquid (40) may then be developed or polymerised into insoluble photoresist by exposure to light. It will further be appreciated that the level of the photoresist coating should preferably be thick enough to cover the highest of the protrusions (32) in order to achieve an initial planar surface on the photoresist layer.

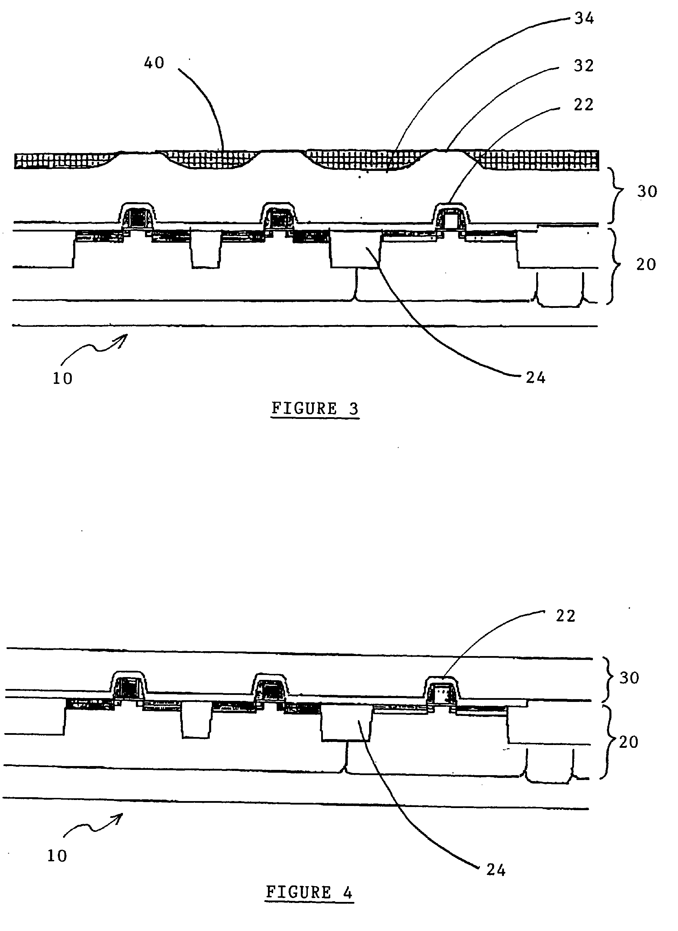

As shown in FIG. 3, the photoresist layer (40) and the irregular top surface of the wafer may then be etched with an etching solution that etches at the same rate both the photoresist and the dielectric layer (30). When the photoresist (40) and dielectric layer (30) are etched at the same rate the planar top surface is maintained as the etching process progresses.

As shown in FIG. 4, the etching may be allowed to progress further to reduce the thickness of the dielectric layer (30) so that the overall number of interconnected patterned layers may be fabricated in a single semiconductor device, thus solving the thick dielectric layer required to overcome the effects of the underlying topological effects mentioned above.

In order that the etching solution dissolves the photoresist (40) and the dielectric layer (30) at the same rate, the etchant may be a solution of a single compound or composition which is capable of dissolving both the photoresist and dielectric layer, or a mixture of etchants which are specific for each of the photoresist (40) and the dielectric layer (30).

Examples of specific etchants are oxide etchants, poly-silicon etchants, metal etchants, photoresist etchants and polyimide etchants, or the combinations of these and other etchants not specifically mentioned herein.

For example, oxide etchants may be employed for etching layers comprising dielectric material which may comprise of conventional materials such as silicon dioxide. For conductive structures, interconnects or materials, poly-silicon and metal etchants may be employed for etching such materials.

The combination of the component etchants comprising the etching solution of the present method may be based on the known selectivity of the particular etchant against the materials to be etched, i.e. (i) the dielectric material or layer, (ii) the conductive structures or interconnects and (iii) the type of photoresist used. The concentration of each of the component etchants may be adjusted according to the known patterns and structures of the underlying layer so that the rate of etching of each of the three materials categorised above is at the same rate.

It will be appreciated that apart from the example of etchants mentioned above, it would be obvious to a person skilled in the art that there are many alternative compounds and compositions that may be used in substitution of the corresponding etchants mentioned to achieve the method or working principle of the present invention. These embodiments are not to be considered as departures from the present invention as illustrated by the examples and specific embodiments described herein and shall be considered as falling within the letter and spirit of the following claims.

## Claims

1. A method of planarizing an irregular surface of a semiconductor wafer, comprising:
- applying a layer of photoresist on the irregular wafer surface to evenly coat over the undesirable topographic features of the wafer so as to provide a top surface of the photoresist layer that is substantially planar; and
- etching the photoresist and dielectric layer at substantially the same rate.

2. A method according to Claim 1 wherein the flowability of the photoresist enables it to be evenly applied on and spread over the irregular wafer surface to achieve a substantially planar top surface.

3. A method according to Claim 1 wherein the photoresist layer and the dielectric layer underlying the photoresist are etched further until the thickness of the layer is desirable for subsequent fabrication.

4. A method according to Claim 1 wherein the etchant includes any one of oxide etchants, poly-silicon etchants, metal etchants, photoresist etchants and polyimide etchants, or combinations thereof.

5. A method according to Claim 4 wherein the oxide etchant is employed for etching layers comprised of dielectric material.

6. A method according to Claim 4 wherein the poly-silicon and metal etchants are employed for etching layers comprised of conductive structures or material.

7. A semiconductor wafer processed according to the method of claim 1.

8. A semiconductor device fabricated with a method as in claim 1.

9. A machine including a semiconductor device according to Claim 8.

10. An etchant formulated for use in a method according to claim 1.

11. An etching solution formulated for use in a method according to claim 1 comprising two or more etchants selective for the materials to be etched at the same rate.
